(19) Europäisches Patentamt
European Patent Office
Office européen des brevets

(11) EP 3 362 511 B1

(12) **EUROPEAN PATENT SPECIFICATION**

(45) Date of publication and mention of the grant of the patent:
**26.06.2019 Bulletin 2019/26**

(21) Application number: **16777894.3**

(22) Date of filing: **26.09.2016**

(51) Int Cl.:
***C08K 9/06*** (2006.01) ***C08K 3/22*** (2006.01)
***H01L 51/44*** (2006.01)

(86) International application number:
**PCT/CH2016/000125**

(87) International publication number:
**WO 2017/063096 (20.04.2017 Gazette 2017/16)**

(54) **SOLUTION-PROCESSABLE HRI INORGANIC/ORGANIC HYBRID OPTICAL FILMS**

ANORGANISCHE/ORGANISCHE HYBRIDE OPTISCHE FOLIEN MIT LÖSUNGSBEARBEITBARER HRI

FILMS OPTIQUES HYBRIDES ORGANIQUES/INORGANIQUES IRH DE SOLUTION POUVANT ÊTRE TRAITÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.10.2015 EP 15002950**

(43) Date of publication of application:
**22.08.2018 Bulletin 2018/34**

(73) Proprietor: **Avantama AG**
**8712 Stäfa (CH)**

(72) Inventors:
- **LÜJCHINGER, Norman Albert**
  **8712 Stäfa (CH)**
- **HARTMEIER, Benjamin**
  **8712 Stäfa (CH)**

(74) Representative: **Grimm, Siegfried**
**E. Blum & Co. AG**
**Vorderberg 11**
**8044 Zürich (CH)**

(56) References cited:
**WO-A1-03/016217 WO-A1-2014/161100**
**JP-A- S6 343 964 US-A1- 2007 129 465**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 362 511 B1

## Description

The present invention provides new hybrid materials, particularly in the form of thin films or micro lenses or encapsulant, having superior optical and thermal properties. The invention further provides for intermediate goods and devices comprising such hybrid materials, and for starting materials to obtain such hybrid materials. The invention also provides for processes of manufacturing said starting materials, said hybrid materials, said intermediate goods; for the use of said starting materials, said hybrid materials, and said intermediate goods.

It is well known that hybrid materials, comprising nanoparticles and polymers, may exhibit desirable optical properties.

Liu et al (WO2010/002562) describe High-RI antireflective films based on zirconia nanoparticles in combination with specific acrylate-phosphate derivatives. The document particularly points to the flexibility of the layers. However, it is considered disadvantageous that the layers obtained according to this document RI values between 1.677 and 1.692 are available only. Further, the layers obtained are only available as layers, having a thickness below 7 microns. For a number of applications, this is not sufficient.

Liu et al (Colloids and Surfaces A: Physicochem. Eng. Aspects 377 (2011) 138-143) disclose high refractive index hybrid films containing TiO2. Although a high RI is reported, the materials disclosed therein show certain drawbacks: As there is a reactive component involved in the formation of the $TiO_2$ network the films need to be cured at high temperatures (140°C). Additionally, reactive components may result in limited storage and shelf life, thus limited industrial applicability. The fact that a sol-gel method is used for the synthesis of the nanoparticles implies that is limited to anatase phase $TiO_2$ particles. Finally, as no surfactant is used for the stabilization of the particles, the method will be strongly limited to certain combinations of solvents and polymer matrices.

Yamazaki et al (EP2586826) describe HIGH-RI hybrid materials based on zirconia nanoparticles, specific resins and sulphur components. The document particularly points to the flexibility of the layers. However, it is considered disadvantageous that the layers obtained according to this document RI values between 1.600 and 1.619 are available only. Further, the process for manufacturing the layers uses sol-gel technology, which is difficult to use in commercial, large-scale applications.

Gonen Williams (US2014/0045323) discloses nanocomposites of high optical transparency; the disclosed nanocomposites comprise silane capped semiconductor nanocrystals selected from ZnO, ZrO2, HfO2 only. The document further discloses methods for manufacturing coatings comprising capped nanoparticles / nanocomposites. It is noted that Gonen Williams fails in disclosing the specific surfactants (2) disclosed in this invention as capping agents. The materials / methods described in this document however do not allow for the manufacture of high quality, high refractive index materials and are limited to specific matrices. With the therein disclosed silane surfactant relatively high amounts of surfactant are necessary to stabilize the particles, which is disadvantageous for reaching very high refractive indices. Additionally the long polyether tail of the disclosed surfactant is considered disadvantageous due to its hygroscopic nature.

Lüchinger et. al (WO2014/161100) discloses dispersions of nanoparticles in alcohols using Diethylphosphatoethyltriethoxysilane as a surfactant and thin films thereof.

The document fails to disclose any type of composites between organic polymers and inorganic nanoparticles. The disclosed materials and processes can therefore neither be used for the manufacturing of high index materials nor for any type of intermediate goods as described in this invention.

Thus, it is an object of the present invention to mitigate at least some of these drawbacks of the state of the art. In particular, it is an aim of the present invention to provide improved hybrid materials, particularly showing excellent optical and thermal properties, and devices comprising such materials. There is a specific need for hybrid materials showing these properties (such as high refractive index and high thermal conductivity) and simultaneously good mechanical stability (such as flexibility or durability) and/or good chemical stability (such as photostability). It is a further aim to provide manufacturing methods for the materials and devices that are simple in upscaling.

These objectives are achieved by the hybrid materials according to claim 1 and the device according to claim 13. Further aspects of the invention are disclosed in the specification and independent claims, preferred embodiments are disclosed in the specification and the dependent claims.

The present invention will be described in more detail below. It is understood that the various embodiments, preferences and ranges as provided / disclosed in this specification may be combined at will. Further, depending of the specific embodiment, selected definitions, embodiments or ranges may not apply.

Unless otherwise stated, the following **definitions** shall apply in this specification:
Percentages are given as weight-%, unless otherwise indicated herein or clearly contradicted by the context.

The term "nanoparticle" is known and particularly relates to solid amorphous or crystalline particles having at least one dimension in the size range of 1 - 100 nm. Preferably, nanoparticles are approximately isometric (such as spherical or cubic nanoparticles). Particles are considered approximately isometric, in case the aspect ratio (longest : shortest direction) of all 3 orthogonal dimensions is 1 - 2. In an advantageous embodiment, the nanoparticles have a mean primary particle size of 2 - 60 nm, preferably 5 - 30 nm (measured by powder X-ray diffraction and calculated by

the Scherrer equation, as described later). Nanoparticles may be homogeneous (i.e. having the same chemical composition along its diameter), or may be of the core shell-type (i.e. comprising an inner material of one chemical composition covered by an outer material having another chemical composition).

The term "hybrid material" is known in the field and denotes materials having an inorganic component (such as titanate nanoparticles, as defined herein) and an organic component (such as a polymeric matrix as defined herein).

The term "suspension" is known and relates to a heterogeneous fluid of an internal phase (i.p.) that is a solid and an external phase (e.p.) that is a liquid. In the context of the present invention, the liquid comprises dissolved matrix molecules. In the context of the present invention, a suspension typically has a kinetic stability of at least 1 day (measured according to complete particle sedimentation). In an advantageous embodiment, the invention provides for a composition with a shelf life of more than 7 days, particularly more than 2 months (hydrodynamic size $D_{90}$ of less than 100 nm). The external phase typically comprises one or more solvents, such as water, alcohols and ketones and the like. In the context of the present invention the term "dispersion" can be used with the same meaning as described above.

The term "matrix" is known in the field and in the context of this invention denotes continuous material encompassing a discontinuous or particulate phase, particularly a nanoparticulate phase.

The term "polymeric matrix" is known in the field and denotes a solid material comprising, and particularly consisting of, matrix molecules whereby monomeric matrix molecules are present in a polymerized state (linearly or crosslinked). Polymeric matrix molecules may additionally be crosslinked (crosslinks between linear polymer chains). The term thus includes homo-polymers, co-polymers and polymer blends.

The term "matrix molecules" is known in the field and includes both, organic polymers (polymeric matrix molecules) and organic monomers (monomeric matrix molecules).

The term "solvent" is known in the field and particularly includes water, alcohols, glycol ethers, nitriles, ketones, ethers, aldehydes and polar aprotic solvents.

The above-mentioned organics can be substituted or unsubstituted and include linear, branched and cyclic derivatives. There can also be unsaturated bonds in the molecule. The above derivatives typically have 1 - 12 carbon atoms, preferably 1 - 7 carbon atoms.

The terms "surfactant", "dispersant", "dispersing agent" and are known in the field and are used synonymously. In the context of the present invention, these terms denote an organic substance, other than a solvent, which is used in suspensions or colloids to improve the separation of particles and to prevent agglomeration or settling. Surfactants, dispersants and dispersing agents can be polymers or small molecules and typically contain functional groups. Surfactants, dispersants and dispersing agents are physically or chemically attached on the particle surface either before or after adding the particles to the external phase. In the context of the present invention, solvent molecules are not considered surfactants, dispersants or dispersing agents.

The term "solution-processing" is known in the field and denotes the application of a coating or thin film to a substrate by the use of a solution-based (=liquid) starting material. In the context of the present invention, solution processing relates to the fabrication of devices and intermediate goods comprising thin nanoparticle hybrid films by the use of one or more liquid suspensions; typically the application of the suspension(s) is/are conducted at ambient pressure and ambient atmosphere. Solution-processing shall include both, coating techniques and printing techniques, as discussed below.

The terms "printing" or "coating" are known in the field and denote specific techniques of solution-processing. There is a variety of different printing or coating types with advantages and drawbacks for each type. A person skilled in the art is in a position to select appropriately. Suitable are, for example coating, particularly roll-to-roll-, slot-die-, spray-, ultrasonic spray-, dip-, reel-to-reel-, blade- coating; or by printing, particularly ink-jet-, pad-, offset-, gravure-, screen-, intaglio-, sheet-to-sheet- printing. Such processes are generally considered advantageous for large-scale production, when compared to vacuum-based processes.

The term "drying" is known in the field and denotes the process of evaporating the solvent in the liquid-processed film. Many processes are known to remove a liquid from a wet thin film of a coated substrate; a person skilled in the art is in a position to select appropriately. Suitable are, for example drying at room temperature or elevated temperature. Drying may take place in air, in a protecting gas, such as nitrogen or argon. Especially suited are gases with low humidity content (e.g. nitrogen, dry air, argon).

The term "titanates" is known in the field and describes substances containing (i.e. comprising or consisting of) titanium oxides.
The term titanates includes both, crystalline and amorphous materials. Titanates may have a variety of crystal structures such as rutile-type (tetragonal) or perovskite-type (orthorhombic) structure.
The term titanates includes both, stoichiometric or non-stoichiometric materials. Because of possible oxygen vacancies, titanates be stoichiometric or non-stoichiometric, typically they are stoichiometric.
The term titanates includes both, pure and doped titanates. Accordingly, in one embodiment, titanates only contain titanium and oxygen. In one further embodiment, titanates contain additional metals, such as strontium, barium, potassium and/or iron. In the context of the present invention, titanates consist of a single crystal phase, e.g. when analyzed by X-Ray diffraction (XRD). This means that, if other metals than titanium are present in the titantate, the atoms of the other metal substitute titanium atoms in the crystal lattice of the titanium dioxide. Accordingly, mixtures of two different oxides (e.g. titanium oxide and strontium oxide) are excluded and consequently not considered titanates.

The term "phosphor" is known in the field and particularly describes materials exhibiting photoluminescence. The term includes both phosphorescent materials with decay times generally > 1ms and fluorescent materials with decay times in the range of nanoseconds.

The present invention will be better understood by reference to the **figures.**

Fig. 1 shows a schematic representation of the inventive hybrid material (30), as it may be present in the form of a thin layer in intermediate goods according to fig. 3-7, wherein (1) represents nanoparticles, (2) represents surfactants, (3) represents a matrix, all of them as defined herein.

Fig. 2 shows a schematic flow diagram of manufacturing devices in line with the present invention. First, a suspension (5) is obtained by combining the starting materials (i.e. nanoparticles (1), surfactant (2), solvent (4), matrix molecules (3)). Second, an intermediate (10) is obtained, comprising the inventive hybrid material (30) on a substrate (20)). Third, the intermediate good is assembled to obtain a device (41, 42, 43).

Fig. 3 shows a schematic set-up of two device structures including a light extraction (light outcoupling) layer (30). According to Fig 3, comprising (bottom-up) a substrate (20), the inventive hybrid material (30), transparent electrode (EL), active layer stack, e.g. OLED emitter stack (AL). According to Fig. 3A the interface between the hybrid material and the substrate may be planar and exhibiting a surface roughness below 100 nm. According to Fig. 3B the interface between the hybrid material and the substrate may be microstructed and exhibiting a surface roughness in the micrometer range (e.g. craters or regular patterns with lateral dimensions of > 1 micrometer and < 100 micrometer. Layer (30) and the transparent electrode (EL) are refractive-index-matched. The transparent electrode (EL) can be a transparent conductive oxide (e.g. indium-tin-oxide (ITO), Aluminium doped Zinc oxide (AZO)) or based on metal nanowires such as silver nanowires or copper nanowires.

Fig. 4 shows a schematic set-up of an anti-reflective coating or a Bragg reflector (depending on the applied film thickness and stack order), comprising a substrate (20), a layer of low refraction index (LRI), the inventive hybrid material (30), a layer of low refraction index (LRI), the inventive hybrid material (30). By the index "n" it is indicated that more than one of such layer stack may be provided. The integer n is not to be confused with index n used in formula (IV).

Fig. 5 shows a schematic set-up, where the inventive hybrid material (30) is present in the form of micro-lenses on a substrate (20).

Fig. 6 shows a schematic set-up of a device structure similar to Fig. 3A but comprising larger scattering elements (SE) randomly dispersed within the inventive hybrid material (30).

Fig. 7 shows a schematic set-up of a device structure where the inventive hybrid material (30) is used as an encapsulant of a light emitting device (ED), whereby the inventive hybrid material additionally comprises larger particles of an inorganic, phosphor (i.e. photoluminescent material) (IP) .

Fig. 8 shows a schematic set-up of a three layer anti-reflective coating, comprising a substrate (20), one layer of the inventive hybrid material (30b), another layer of the inventive hybrid material (30a) exhibiting a different refractive index and a layer of low refractive index (LRI).

In a **first aspect,** the invention relates to a solid hybrid material comprising nanoparticles (1) selected from the group of metal oxides, surfactants (2) as outlined herein and a specific polymeric matrix (3), as outlined herein.

This aspect of the invention shall be explained in further detail below:

In an advantageous embodiment, the invention relates to a solid hybrid material (30) comprising 50-90 wt-% (preferably 65-88 wt-%, most preferably 75-85 wt-%) nanoparticles (1) selected from the group of metal oxides; 1-20 wt-% (preferably 2-10 wt-%, most preferably 4-7 wt-%) surfactants (2) selected from the group of phosphate ester silanes; 9-49 wt-% (preferably 10-30 wt-%, most preferably 11-21%) polymeric matrix (3) selected from the group of transparent polymers.

These hybrid materials have outstanding optical properties and mechanical properties and may therefore find applications as outlined herein. These materials are particularly suitable as an IEL layer (internal extraction layer), LED encapsulants, Bragg reflectors or antireflection coatings for intermediates and devices as discussed below. Particularly important optical and mechanical properties in this context are high refractive index, high transparency, high thermal

conductivity, low haze at high thickness, low absorption, high temperature stability, and low surface roughness. These requirements can be met with the materials of the present invention.

These hybrid materials are further very simple in processing. As further outlined below, these materials may be processed in solution, still retaining the beneficial optical and mechanical properties. This avoids vacuum-deposition methods or other expensive manufacturing methods.

Transparency: Advantageously, the materials (1), (2), (3) are selected to not absorb within the visible wavelength range, and not scatter light within the visible wavelength i.e. they are transparent. In a preferred embodiment, a 1mm thick specimen of the selected polymer matrix (2) absorbs less than 10% in the visible light range of and shows a haze of less than 10% in the visible light range. The skilled person is in a position to identify appropriate monomers / polymers to achieve this property.

**Nanoparticles** (1): The term nanoparticles is described above. In an advantageous embodiment, such nanoparticles have a bulk refractive index of n>2.2. In a further advantageous embodiment, such nanoparticles have a bulk thermal conductivity of κ>2 W/mK. Such nanoparticles are commercial items and may be obtained by known manufacturing methods.

Advantageously, the nanoparticles are titanates of formula (I),

$$M_xTiyO_z \qquad (I),$$

wherein

M represents alkaline metal or alkaline earth metal,
x represents 0, a real number below 1 or 1,
y represents 1 or a real number below 1 but excluding 0,
z represents a real number below 1 but excluding 0, provided that
z=x/2+2*y if M represents an alkaline metal or
z=x+2*y if M represents an alkaline earth metal or
z=2*y if x=0.

Particularly suitable titanates are selected from the group consisting of TiO2 (all possible crystalline phases) SrTiO3, BaTiO3.

Very particularly preferred titanates are selected from the group consisting of SrTiO3, TiO2 (rutile phase).

According to the invention, said titanates may be selected from one single species or from a mixture of species. Accordingly, the inventive hybrid materials may comprise one species of titanate nanoparticles (e.g. pure TiO2) or may comprise two or more species of titanate nanoparticles (e.g. pure TiO2 nanoparticles and pure SrTiO3 nanoparticles). Such selection of species may be helpful for fine-tuning properties as required by the intended use. In one embodiment, said nanoparticles comprise a first group of particles exhibiting high refractive index and a second group of particles exhibiting high thermal conductivity.

According to the invention, said titanates may be stoichiometric or non-stoichiometric compounds as defined herein. In the context of the present invention compounds are considered stoichiometric if the amount of oxygen atoms in the compound strictly follows formula (I) and are considered non-stoichiometric if there is an excess or a lack of oxygen atoms i.e. the actual amount of oxygen is smaller or larger then the value x given in formula (I). These oxygen defects may occur in any of the mentioned titanates.

The nanoparticle **size** is 2-60nm, preferably 5-30, most preferably 8-18nm. The nanoparticle size corresponds to a mean crystallite size measured by XRD and calculated by the Scherrer equation:

$$\tau = \frac{K\lambda}{\beta\cos(\theta)}$$

wherein;

τ is the mean size of the crystalline domains
K is a dimensionless shape factor (typically approx. 0.9)
λ is the X-ray wavelength
β is the peak broadening at the half-maximum (FWHM) after subtracting the instrumental peak broadening
θ is the Bragg angle.

According to the invention, the nanoparticles may be amorphous. This may be beneficial, e.g. in the case of

TiO2 the photocatalytic effect of TiO2 (Anatase) can be reduced (avoid degradation of organic matrix).

According to the invention, the nanoparticles may be of a **core-shell structure,** whereby the core and shell are composed of different oxides. Preferably, the shell does amount to less than 20 wt-% (based on oxide weight) of the whole particle.

Preferably, the core is composed of a titanate as described in formula (I).

In one embodiment, the shell is composed of titanates as described in formula (I), but different to the core.

In a further preferred embodiment, the shell is composed of other metallic oxides, preferably Al2O3 or ZrO2, particularly preferably Al2O3. This embodiment shows particularly beneficial properties for a number of applications / devices. Although the surface of these nanoparticles (1) comprises metallic oxides other than titanates, these particles are compatible with the surfactants (2) as described herein. Hybrid materials (30) comprising these core-shell nanoparticles are particularly desirous, as outlined below in 2nd aspect of the invention.

**Surfactants (2):** The term surfactants is described above. It was found that the class of phosphate ester silanes show very beneficial effects. These surfactants are predominantly located on the surface of the nanoparticles. Without being bound to theory, it is believed that these surfactants ensure compatibility between the nanoparticles and the polymer matrix. Secondly, the surfactants of this invention allow high refractive indices of the hybrid material due to the very low amount of surfactant needed per amount of nanoparticles. Such surfactants are commercial items or may be obtained according to known procedures. These surfactants are explained in further detail below.

Advantageously, these surfactants are of formula (II),

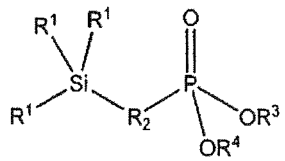

(II),

wherein:

$R^1$ independently represents $C_1$-$C_4$ alkyl, $C_1$-$C_4$-alkoxy, $C_1$-$C_4$-alkoxy-$C_1$-$C_4$-alkyl;

$R^2$ represents $C_1$-$C_{10}$ alkyl, saturated or unsaturated $C_3$-$C_{10}$ carbocyclic groups;

$R^3$ represents H, $C_1$-$C_6$ alkyl or $C_1$-$C_4$-alkoxy-$C_1$-$C_4$-alkyl

$R^4$ represents $C_1$-$C_6$ alkyl or $C_1$-$C_4$-alkoxy-$C_1$-$C_4$-alkyl.

Advantageously, $R^1$ represents $C_1$-$C_4$-alkoxy. Advantageously, $R^2$ represents $C_1$-$C_{10}$ alkyl. Advantageously, $R^3$ represents $C_1$-$C_6$ alkyl. Advantageously, $R^4$ represents $C_1$-$C_6$ alkyl.

A particularly preferred compound of that class is Diethylphosphato-ethyl-triethoxy-silane. This corresponds to a compound of formula (II), wherein R1 represents ethoxy, R2, R3 and R4 represent ethyl.

**Polymeric Matrix (3):** It was found that nanoparticles combined with the surfactants as described herein are compatible with a wide variety of polymers. In principle the concept of the present invention can be applied to any polymer matrix that is compatible with solvents, which themselves are compatible to the disclosed surfactants.

For many applications, it is beneficial to use a transparent hybrid material. Advantageously, the invention relates to hybrid materials where polymer matrix (3) is selected from the group of transparent polymers.

Several classes show very beneficial effects, namely selected from the group of silazane polymers, sulfone polymers, acrylate polymers, epoxy polymers, vinyl polymers, urethane polymers, imide polymers. Particularly preferred classes of polymers are selected from the group of silazane polymers, sulfone polymers, acrylate polymers, and vinyl polymers. Most particularly preferred classes of polymers are selected from the group of silazane polymers and sulfone polymers. It was found that these classes of polymers show beneficial effects on optical, mechanical and/or applicability properties of the coatings as described below (second aspect of the invention).

The polymeric matrix may be either characterized by its repeating units or by the starting materials used for polymerisation. Preferred polymers are outlined below:

Advantageously, the silazane polymers are formed by reaction of ammonia with a substituted silane and typically have repeating units of formula (III),

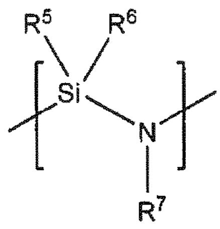

(III)

wherein R5, R6 and R7 independently of each other represent hydrogen, possibly substituted alkyl, aryl, vinyl or (trialkoxysilyl)alkyl, preferably hydrogen, methyl, ethyl, propyl, isopropyl, butyl, isobutyl, tert-butyl, phenyl, tolyl, vinyl or (3-triethoxysilyl)propyl, 3-(trimethoxysilylpropyl), most preferably methyl and hydrogen. In such polysilazanes, the substituents R5, R6 and R7 may vary for each repeating unit, i.e. these polymers are statistic copolymers. These polymers generally have a number average molecular weight of 150 to 150000 g/mol and may additionally comprise a catalyst.

Such polymers (or its monomers respectively) are commercial items and / or available using known methods.

Advantageously, the sulfone polymers are formed by reaction of an aromatic diol with an Di (halogenaryl) sulfone and typically have repeating units of formula (IV),

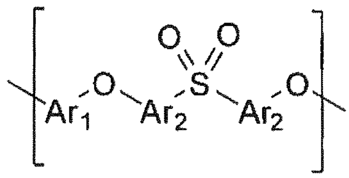

(IV)

wherein

$Ar_1$ represents a phenyl, a phenylether, a phenylthioether, a bisphenol,
said phenyl optionally being substituted by 1-3 substituents selected from the group of C1-4 alkyl, phenyl, halogen, hydroxy.
$Ar_2$ represents phenyl,
said phenyl optionally being substituted by 1-3 substituents selected from the group of C1-4 alkyl, phenyl, halogen, hydroxy.

$Ar_1$ preferably represents resorcinol, bisphenol A and bisphenol S. Particularly preferred are bisphenol A and bisphenol S.

One particularly preferred polymer of that class has repeating units of formula

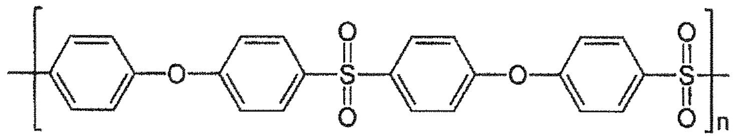

Such polymers (or its monomers respectively) are commercial items and / or available using known methods.

In a further embodiment, the hybrid material may comprise **further additives.** These additives are part of the polymeric matrix; suitable additives include rheology modifiers (such as PVP K90) and polymerisation initiators (such as Darocur 1173).

In a further embodiment, the hybrid material may comprise up to 30wt% of **additional elements** with a size of 100 nm - 1000 nm, particularly for influencing scattering properties. The refractive index of the scattering elements is < 1.5 or > 2.2 , preferably < 1.4 or > 2.4. Such elements may be inorganic particles, organic particles or air inclusions. Scattering elements are typically randomly distributed within the hybrid material and are illustrated in fig. 6. Hybrid films including such scattering elements (SE) may act as IEL or light incoupling layers in lighting devices, displays or solar cells.

In a further embodiment, the hybrid material may comprise an **inorganic phosphor (IP).** Suitable IPs are known and include photoluminescent materials. Typically, such IP are present in the form of larger particles. Suitable particle sizes are in the range of 100nm - 100um. In such embodiment, the hybrid material acts as an encapsulant. Fig. 7 shows a schematic set-up of a device structure where the inventive hybrid material (30) is used as an **encapsulant**

of a light emitting device (ED). Suitable EDs are known and include blue GaN LED.

As it becomes apparent from the above, a high flexibility is obtained for providing hybrid materials comprising (or consisting of) nanoparticles, surfactants and polymer matrix as described herein. This flexibility allows

- to adjust the refractive index between 1.5 and 2.0;
- to adjust film thickness in the range of 30 nm - 30'000 nm;
- to obtain highly transparent films (i.e. no haze, even at comparatively thick films (>10 μm));
- to obtain colour-less films (i.e. no absorption of the materials in the visible wave-length);
- to obtain films that are stable toward temperature and mechanical stress.

These benefits are obtained due to the combination of specific starting materials (1), (2) and (3) as outlined herein. Without being bound to theory, it is believed that the specific combination of nanoparticles, surfactants and polymer matrix enable the superior properties of the solid hybrid material as described herein:

From a transparency point of view, the nanoparticles need to be as small as possible in order not to interfere with the visible light. In order to maximize the refractive index however, the particles need to be as large as possible so that as little as possible surfactant is used and as much as possible high refractive index polymer matrix can be added. It is known in the field that a randomly arranged packing of spheres shows a volume density of 50%. As the titanates used in the present invention have a density of approximately 4 to 5 times higher than organic material it follows, that in order to completely fill up the pores of the randomly arranged nanoparticle packing approximately 20 wt-% organic matrix should be combined with 80 wt-% nanoparticles. So if the maximum amount of allowable organic matrix is fixed, the goal is to reduce the amount of surfactant in order to increase the allowable amount of beneficiary polymer matrix material, thus leading to improved optical and mechanical properties. It is therefore also the achievement of the present invention combining optimal nanoparticle size with specific surfactants that only needs minimal application concentrations for complete stabilization and minimal agglomeration of all particles. Finally the choice of the polymer matrix allows for the fulfilment of the second part of properties (Low absorption in the visible light range, High temperature stability (>200°C), high durability against photoinduced degradation, low surface roughness, High mechanical stability) explained herein. Depending on the polymer matrix, one or more of these requirements can be met.

In a **second aspect,** the invention relates to coatings comprising the inventive hybrid material, to intermediate goods comprising such coatings and to devices comprising such intermediate goods

It was surprisingly found that the material described above (first aspect) is suitable for obtaining thin films, microlenses and encapsulants with superior optical properties. Specifically, the materials show:

- high refractive index (>1.75)
- low haze (not visible by eye) at high thickness (>10 μm).

Further, several other attributes may be important for certain applications. These attributes can, depending on the application requirements, be fulfilled separately or in combination. Amongst these are:

- Low absorption in the visible light range
- High temperature stability (>200°C)
- Low surface roughness
- High mechanical stability
- High durability against photoinduced degradation.

This aspect of the invention shall be explained in further detail below:

Coating (30): The term coating shall include both, continuous coatings and dis-continuous coatings. Such coatings may be applied to a substrate by conventional means. Particularly, such coatings may be applied on a substrate already having one or more coatings. Further, additional coatings may be applied on top of the inventive coating.

In one embodiment of the inventive coatings, the hybrid material comprises nanoparticles having a size of 5 - 30 nm, preferably 8 - 18 nm.

In one embodiment of the inventive coatings, the nanoparticles are of the core-shell type, particularly comprising a titanate core according to formula (I), preferably a $TiO_2$ rutile core and a metal oxide shell selected from $Al_2O_3$ or $ZrO_2$ shell, preferably a $Al_2O_3$ shell. Such coatings retain a desirous high refractive index, but show improved chemical stability when exposed to radiation, such as UV radiation or ambient radiation. These core-shell nanoparticles therefor allow for the manufacturing of hybrid materials in the form of thin layers (i) showing excellent refractive index (e.g. 1.75 or more) in combination with moderate mechanical stability and excellent chemical stability or (ii) showing moderate refractive index (e.g. in the rage of 1.7) in combination with excellent mechanical stability and excellent chemical stability.

In one embodiment, the coating is continuously applied to a substrate. Such coating is referred to as "**a layer**", the

thickness thereof preferably having a thickness of 30nm to 100μm, most preferably of 70 nm - 20 μm. Compared to the prior art, it is possible to obtain relatively thick layers.
In an alternative embodiment, the coating is discontinuously applied to a substrate. Such coating is typically applied in the form of a multitude of "**microlenses**", the diameter thereof preferably being 1 - 500 μm, most preferably 3 - 30 μm.
In a further alternative embodiment, the coating is discontinuously applied to form an **encapsulant.** Such encapsulant is typically applied to cover an emitting device (ED), having a thickness of 1 μm - 3000 μm.

In a further embodiment, the inventive material exhibits a surface roughness below 5nm and/or a mechanical stability of at least 2H (according to pencil hardness test).

Intermediate good (10): The term "intermediate good" is known in the field and relates to goods that are an integral part of devices as outlined below. Such intermediate goods include rigid or flexible substrates coated with the hybrid material of the present invention. Such substrates may me polymeric (e.g. PET, PC, PANI) or inorganic (e.g. metal foils, glass sheets).

The structure of the intermediate good may vary depending on its intended use. Preferred are intermediate goods having the structure according to fig. 3 or having the structure according to fig. 4; or having the structure according to fig. 5; or having the structure of fig. 6. Accordingly, the invention provides for an intermediate good having either of the following (bottom-up) structures:

- Substrate (preferably planar, surface roughness below 100nm) (20) / inventive hybrid material (30) / transparent electrode (EL) / active layer stack (preferably OLED emitter stack (AL)) [In this embodiment, material (30) acts as an index matching layer, Fig. 3A]; or
- Substrate (preferably microstructured, surface roughness in the micrometer range below 100 micrometer) (20) / inventive hybrid material (30) / transparent electrode (EL) / active layer stack (preferably OLED emitter stack (AL)) [In this embodiment, material (30) acts as a light extraction layer, Fig. 3B]; or
- Substrate (20) / multiple units of low refractive index layer (LRI) and the inventive hybrid material (30) or Substrate (20) / multiple units of the inventive hybrid material (30) and low refractive index layer (LRI), [ thus acting as a bragg reflector or anti reflection coating, Fig. 4]; or
- substrate (20) / the inventive hybrid material (30) in the form of micro-lenses [Fig. 5]; or
- Substrate (20) / inventive hybrid material (30) comprising additional scattering elements (SE) / transparent electrode (EL) / active layer stack (particularly e.g. OLED emitter stack (AL)) [In this embodiment, material (30) /(SE) acts as a light extraction layer, Fig. 6]; or
- Substrate (20) / Emitting Device (ED)/ inventive hybrid material (3) comprising inorganic phosphors (IP) [Fig. 7; , preferably where ED is a blue GaN LED device]; or
- Substrate (20) / the inventive hybrid material (30a) / the inventive hybrid material (30b) exhibiting a different refractive index / low refractive index layer (LRI), [thus acting as a three layer anti-reflection coating, Fig. 8].

In a further embodiment, the invention provides for the use of the inventive hybrid material as Bragg reflectors or anti reflecting coatings, as outlined in Fig. 4. In combination with a material of low refractive index (LRI), the inventive hybrid material (30) of the present invention provides for an intermediate acting as a Bragg reflector or anti reflection coating. This property may be achieved by stacking alternating layers of low refractive index (LRI), and high refractive index (30) material and accurately choosing the film thicknesses. Such multilayer stack may be tuned to reflect certain desired parts of the light spectrum while transmitting the others. It is noted that in order to achieve optimum performance each high refractive index layer (30) and each low refractive index layer (LRI) may be of a different specific composition and thus exhibit a different refractive index from the other layers. In this embodiment, the low refractive index layer (LRI) may be composed of a porous silica nanoparticle structure or a low refractive index polymer. Accordingly, the invention also provides for intermediates as described herein having Anti-reflecting properties or having properties of a Bragg reflector.

Consequently, the invention also provides for an intermediate good comprising a substrate (20) coated with at least one coating (30) as described herein.

Device (40): The intermediate goods (10) described herein may find application in a wide variety of devices (40), including devices containing a display (41), devices that emit light (42), fenestration and products containing an optical authentication element (43), optical lenses. Due to the wide variety of polymer matrices possible, an extremely large variety of devices are now available. This is considered a significant advantage of the present hybrid materials, as customer-specific materials may be provided, tailored to the specific needs of the intended application.

Devices containing a display, such as an OLED according to Fig. 3A or 3B, are known and include computer monitors, TV Screens, hand-held electronic devices (watches, mobile phones, smart phones, tablet computers, navigation systems).

Devices that emit light, such shown in Fig. 3A or 3B, are known and include illuminants for space lighting. Such illuminants may be planar or non-planar and may include organic LED (OLED) or inorganic LED technology.

Fenestration includes windows and doors, both in buildings and in furniture.

Products containing an optical authentication element are known and include bank notes, credit cards, tickets, vouchers, blisters (e.g. for pharmaceuticals and contact lenses) and packages (e.g. for high value products such as fragrances, pharmaceuticals).

In an advantageous embodiment of the devices according to Fig. 3A or 3B, the electrode is ITO, the hybrid material exhibits a refractive index of 1.75 - 1.95 and a mean film thickness of 1 - 20 micron.

In a **third aspect,** the invention relates to a process for manufacturing hybrid materials, coatings, intermediate goods as described herein.

As a key benefit, the intermediate goods are available through an all-solution-process. The hybrid materials are readily applicable to substrates. As a further benefit, a long lifetime (e.g. shelf life more than 1 month) of the starting material (specifically the suspensions as described below, forth aspect) was achieved. This allows for excellent up-scaling and commercialization possibilities of the materials described herein.

This aspect of the invention shall be explained in further detail below:

In one embodiment, the invention provides for a **method for manufacturing a hybrid material** as defined herein, comprising the steps of providing a suspension as defined below; removing the organic solvent (4), optionally by the aid of reduced pressure and / or heat; optionally curing the thus obtained material.

In one embodiment, the invention provides for a **method for manufacturing an intermediate** good as described herein, comprising the steps of providing a suspension as defined below; providing a support material which is optionally coated with one or more layers; coating or printing said optionally coated support material with said suspension; optionally providing further coatings on said coated substrate; and / or optionally post - treatment of said coated support material.

Each of the individual steps outlined below are known per se, but not yet applied to the inventive materials.

In a **forth aspect,** the invention relates to a suspension, said suspension particularly useful for the manufacturing of hybrid materials as described herein. As a key benefit, the suspensions described herein show good shelf life, are readily applicable to a substrate by using conventional coating techniques and do not need any complicated posttreatment.

This aspect of the invention shall be explained in further detail below:

In one embodiment, the invention provides for a suspension (5) comprising 0.5-80 wt-%, preferably 2-50 wt-%, most preferably 5-30 wt-% nanoparticles (1) as described herein; 0.01-20 wt-%, preferably 0.1-5 wt-%, most preferably 0.5-2 wt-% surfactants (2) as described herein; 0.09-99 wt-%, preferably 0.5-49 wt-%, most preferably 1-10wt-% matrix molecule (3) as described herein; 0-99 wt-%, preferably 45-90 wt-%, most preferably, 65-85 wt-% solvent (4) selected from the group of water, alcohols, glycol-ethers, ketones, and aprotic polar solvents.

As indicated above, the amount of solvents may be low or even zero. In the case of low solvent amounts, the matrix molecule also acts as a solvent phase.

Solvents (4): It was found that five classes of solvents show very beneficial effects, namely: water, alcohols, glycol-ethers, ketones, and aprotic polar solvents. This also includes combinations of two or more of such solvents.

These solvents are explained in further detail below.

Advantageously, said alcohols are of formula (IIX)

$$R_{12}\text{-OH} \qquad \text{(IIX)}$$

wherein $R_{12}$ represents C1-8 alkyl. Preferred alcohols are selected from the group of methanol, ethanol, isopropanol, propanol, and butanol.

Advantageously, said glycol-ethers are of the formula (IX-I) or (IX-II):

$$\text{HO-}R_9\text{-O-}R_{11} \qquad \text{(IX-I),}$$

$$\text{HO-}R_9\text{-O-}R_{10}\text{-O-}R_{11} \qquad \text{(IX-II)}$$

whereby $R_9$ is $C_nH_{2n}$, (n = 1-4),
whereby $R_{10}$ is $C_nH_{2n}$, (n = 1-4),
whereby $R_{11}$ is $C_mH_{2m}CH_3$ (m = 0-4) .

Most advantageously, said glycol ether is Propoxy-ethanol or methoxy-propanol.

Suitable ketones are known in the field. Advantageously, said ketones are acetone and MEK.

Suitable aprotic polar solvents are known in the field. Advantageously, said aprotic polar solvents are preferably selected from the group of dimethyl sulfoxide (DMSO), N-methyl pyrrolidone, dimethyl formamide, dimethyl acetamide (DMAC), and gamma butyrolacetone. Particularly preferred aprotic polar solvents are DMSO and DMAC.

In one embodiment of the invention, the inventive suspension may additionally contain non-polar solvents, such

as toluene or xylene. Such non-polar solvents may be added to enhance the miscibility with the polymer matrix. Suitable amounts of such non-polar solvents are in the range of up to 1/2 based on the amount of aprotic polar solvent (4).

Such suspensions may be manufactured by methods known in the art. In one embodiment, such method comprises the steps of combining components (4), (1) and (2) to obtain a first suspension; combining components (4) and (3) and optionally non-polar solvent, to obtain a first solution; combining said first suspension and said first solution to obtain the suspension as described herein.

To further illustrate the invention, the following **examples** are provided.

Experiment 1

Commercially available rutile ($TiO_2$)/$Al_2O_3$ core/shell particles were purchased from Sachtleben. The product Hombitec RM 110 was specified to have 12nm particle size. The mean crystallite size was measured with a Rigaku MiniFlex 600, an SC-70 Detector, measured from 10° to 70° at 0.01° step size by using the Scherrer equation. The mean crystallite size of the $TiO_2$ particles was 14.6 nm.

For the silanisation step 40wt% of nanopowder (as described above), 4wt% of Diethyl-phosphatoethyl-triethoxysilane (ABCR) [according to the invention] or Methoxy-triethyleneoxypropyl-tri methoxysilane (Gelest Inc.) [for camparision], 4wt% Water (Fluka) and 52wt% Ethanol (Fluka) were mixed by shaking and placed in an open container in an oven at 65°C for 4 days in order to let the silanization reaction occur and the residual non-reacted surfactant as well as the solvent evaporate. By measuring the total weight before and after silanisation/drying the remaining surfactant on the particles was measured to be
29wt% (Diethyl-phosphatoethyl-triethoxysilane) and 47wt% (Methoxy-triethyleneoxypropyl-tri methoxysilane) of the initially added amount.

For the preparation of suspensions, 10wt% of each obtained nanopowder (as described above) and 90wt% of Ethanol (Fluka) were dispersed by ball-milling for 1 h. The finally prepared suspensions are translucent and stable for more than 1 month. A visual inspection shows, that the suspension with inventive Diethyl-phosphatoethyl-triethoxysilane shows more transparency and thus smaller hydrodynamic particle size (better dispersion) than the suspension with Methoxy-triethyleneoxypropyl-tri methoxysilane. From a technical point of view, this is a significant difference.

The hydrodynamic particle size was determined by a gravitational analysis technique (Lumisizer 610, 2mm polycarbonate cuvette, Volume-weighted distribution):
The hydrodynamic particle size was determined as:

Diethyl-phosphatoethyl-triethoxysilane
[according to the invention]

D10 = 19nm
D50 = 25nm
D90 = 31nm
D99 = 36nm

Methoxy-triethyleneoxypropyl-tri methoxysilane
[comparative]

D10 = 23nm
D50 = 31nm
D90 = 42nm
D99 = 47nm

Experiment 2

For the silanisation 40wt% of the rutile($TiO_2$)/$Al_2O_3$ core/shell particles described in experiment 1, 8wt% of Diethyl-phosphatoethyl-triethoxysilane (ABCR), 8wt% Water (Fluka) and 44wt% Ethanol (Fluka) were mixed by shaking and placed in an open container in an oven at 65°C for 4 days in order to let the silanization reaction occur and the residual non-reacted surfactant as well as the solvent evaporate.

For the preparation of suspensions, 5wt% of the obtained nanopowder (as described above) and 95wt% of γ-butyrolactone (Aldrich) were dispersed by ball-milling for 1 h. The finally prepared suspension is translucent and stable for more than 1 month.

This suspension was mixed 1:1:1 (volume ratio) with γ-Butyrolactone and a 5 wt% solution of polysilazane (Merck) in xylene. The resulting mixture was spin coated at 1000rpm and dried at 90°C. The properties of the achieved

film were measured with a Filmetrics F-10-RT-UV reflectometer. A film thickness of 80 nm and a refractive index of 1.68 were measured at these conditions.

Approximately 0.25ml of same above described mixture was dropped onto a microscope slide and dried at 90°C. The obtained film was very thick (>10um), homogeneous and transparent. These properties are important for manufacturing of high-performing devices and show the potential of the inventive compositions.

Experiment 3

10wt% of the silane treated powder from experiment 2 and 90wt% of ethylene glycol monopropyl ether (Sigma Aldrich) were dispersed by ball-milling for 1 h. The finally prepared suspensions are translucent and stable for more than 1 month.

To 2g of this suspension, 0.035g of O-phenylphenoxy ethyl acrylate (Jobachem), 0.035g of a premixed solution of 2-Hydroxy-2-methylpropiophenone (Sigma Aldrich) 5 wt-% in ethylene glycol monopropyl ether (Sigma Aldrich) was added. The obtained mixture was then spincoated at 2000rpm and UV-cured under a 100W UV lamp (Hoenle UVACube 100). The properties of the achieved film were measured with a Filmetrics F-10-RT-UV reflectometer. A film thickness of 222 nm and a refractive index of 1.86 were measured at these conditions. This is a particular high refractive index.

Experiment 4

10wt% of the silane treated powder from experiment 2 and 90wt% of dimethyl sulfoxide (Aldrich) were dispersed by ball-milling for 1 h. The finally prepared suspension istranslucent and stable for more than 1 month.

To 2g of this suspension, 0.5g of a premixed solution of polyethersulfone (Veradel) 10 wt-% in dimethyl sulfoxide (Acros) was added. The obtained mixture was then coated on a doctor blader at 1mm/s coating speed and dried at 100°C. The properties of the achieved film were measured with a Filmetrics F-10-RT-UV reflectometer. A film thickness of 170 nm and a refractive index of 1.87 were measured at these conditions. Again, this is a particular high refractive index.

Experiment 5

Strontium titanate ($SrTiO_3$) nanoparticles were synthesized by flame spray synthesis. For the preparation of the precursor, 90.6g Sr-acetate (ABCR) was added to 679g and 2-ethylhexanoic acid and dissolved by heating the mixture for 1 hour at 150°C. 125.2g Ti-isopropoxide (Aldrich) was added after cooling down to room temperature. The obtained solution was diluted with THF 7.5:4.5 by weight. The precursor then was fed (7 ml $min^{-1}$, HNP Mikrosysteme, micro annular gear pump mzr-2900) to a spray nozzle, dispersed by oxygen (15 1 $min^{-1}$, PanGas tech.) and ignited by a premixed methane-oxygen flame ($CH_4$: 1.2 1 $min^{-1}$, $O_2$: 2.2 1 $min^{-1}$). The off-gas was filtered through a glass fiber filter (Schleicher & Schuell) by a vacuum pump (Busch, Seco SV1040CV) at about 20 $m^3$ $h^{-1}$. The obtained oxide nanopowder was collected from the glass fiber filter.

The mean crystallite size was measured with a Rigaku MiniFlex 600, an SC-70 Detector, measured from 10° to 70° at 0.01° step size by using the Scherrer equation. The mean crystallite size of the SrTiO3 particles was 13 nm.

For the silanisation 40wt% of the SrTiO3 particles described in experiment 1, 8wt% of Diethyl-phosphatoethyl-triethoxysilane (ABCR), 8wt% Water (Fluka) and 44wt% Ethanol (Fluka) were mixed by shaking and placed in an open container in an oven at 65°C for 4 days in order to let the silanization reaction occur and the residual non-reacted surfactant as well as the solvent evaporate.

For the preparation of suspensions, 10wt% of the obtained nanopowder (as described above) and 90wt% of Ethanol (Fluka) were dispersed by ball-milling for 1 h. The finally prepared suspension is translucent and stable for more than 1 month.

To 2g of this suspension, 0.05g of O-phenylphenoxy ethyl acrylate (Jobachem), 0.05g of a premixed solution of 2-Hydroxy-2-methylpropiophenone (Sigma Aldrich) 5 wt-% in ethylene glycol monopropyl ether (Sigma Aldrich) and 2g of ethylene glycol monopropyl ether was added. The obtained mixture was then doctor bladed at 5mm/s coating speed and UV-cured under a 100W UV lamp (Hoenle UVACube 100). The properties of the achieved film were measured with a Filmetrics F-10-RT-UV reflectometer. A film thickness of 120 nm and a refractive index of 1.76 were measured at these conditions.

This experiment shows that a large variety of nanoparticles may be successfully used.

## Claims

1. A solid hybrid material (30) comprising

- 50-90 wt-% nanoparticles (1) selected from the group of metal oxides;
- 1-20 wt-% surfactants (2) selected from the group of phosphate ester silanes;
- 9-49 wt-% polymeric matrix (3) selected from the group of transparent polymers,

**characterized in that** the phosphate ester silanes are of formula (II),

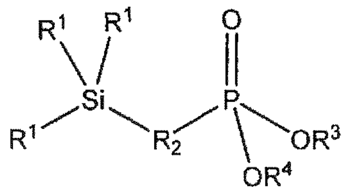

(II),

wherein:

$R^1$ represents $C_1$-$C_4$ alkyl, $C_1$-$C_4$-alkoxy, $C_1$-$C_4$-alkoxy-$C_1$-$C_4$-alkyl;
$R^2$ represents $C_1$-$C_{10}$ alkyl, saturated or unsaturated $C_3$-$C_{10}$ carbocyclic groups;
$R^3$ represents H, $C_1$-$C_6$ alkyl or $C_1$-$C_4$-alkoxy-$C_1$-$C_4$-alkyl
$R^4$ represents $C_1$-$C_6$ alkyl or $C_1$-$C_4$-alkoxy-$C_1$-$C_4$-alkyl.

**2.** The hybrid material according to claim 1, wherein in the surfactant (2)

$R^1$ represents $C_1$-$C_4$-alkoxy;
$R^2$ represents $C_1$-$C_{10}$ alkyl;
$R^3$ represents $C_1$-$C_6$ alkyl;
$R^4$ represents $C_1$-$C_6$ alkyl.

**3.** The hybrid material according to claim 1, wherein the surfactant (2) is Diethylphosphato-ethyl-triethoxy-silane.

**4.** The hybrid material according to any of claims 1 to 3, wherein the nanoparticles (1)

- have a bulk refractive index of n>2.2; and / or
- have a bulk thermal conductivity of $\kappa$>2 W/mK.

**5.** The hybrid material according to any of claims 1 to 4, wherein the nanoparticles (1) comprise a first group of particles exhibiting high refractive index and a second group of particles exhibiting high thermal conductivity.

**6.** The hybrid material according to any of claims 1 to 5, wherein the nanoparticle (1) are of a core-shell structure, whereby

- the core is selected from the group of metal oxides ; and
- the shell is $Al_2O_3$; and

whereby the shell preferably amounts to less than 20 wt-% (based on oxide weight) of the whole particle.

**7.** The hybrid material according to claim 1 to 6,
wherein in the nanoparticles (1) said metal oxide is selected from titanates of formula (I)

$$M_xTiyO_z \qquad (I),$$

whrerein.

M represents alkaline- or alkaline earth metal;
x represents 0, a real number below 1 or 1;
y represents 1 or, a real number below 1 but excluding 0;
z represents a real number below 1 but excluding 0;

provided that:

$z=x/2+2*y$ if M represents an alkaline metal or
$z=x+2*y$ if M represents an alkaline earth metal or
$z=2*y$ if $x=0$;

preferably rutile phase $TiO_2$.

**8.** The hybrid material according to any of claims 1 to 7, wherein the polymer matrix (3) is selected from the group of silazane polymers, sulfone polymers, acrylate polymers, and vinyl polymers.

**9.** The hybrid material according to any of claims 1 to 8, wherein the polymer matrix (3)is selected from silazane polymers of formula (III) and polysulfone polymers of formula (IV)

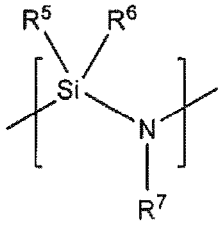

(III)

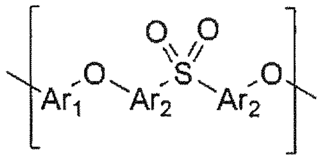

(IV)

wherein

$R^5$, $R^6$, $R^7$ independently of each other represent hydrogen, possibly substituted alkyl, aryl, vinyl or (trialkoxysilyl)alkyl independently in each polymer repeating unit;
$Ar^1$ represents a phenyl, a phenylether, a phenylthioether, a bisphenol (said phenyl optionally being substituted by 1-3 substituents selected from the group of C1-4 alkyl, phenyl, halogen, hydroxyl), preferably represents bisphenol A or bisphenol S;
$Ar^2$ independently represents phenyl (said phenyl optionally being substituted by 1-3 substituents selected from the group of C1-4 alkyl, phenyl, halogen, hydroxy), preferably represents phenyl.

**10.** The hybrid material according to any of claims 1 to 9 in the form of a thin layer, in the form of micro lenses or in the form of an encapsulant,

- said nanoparticles having a size of 5 - 30 nm;
- said thin layer having a thickness of 30 nm - 100 μm; and / or
- said micro lenses having a diameter of 1 - 500 μm; and / or
- said encapsulant having a thickness of 1 μm - 3000 μm.

**11.** An intermediate good (10) comprising a substrate (20) coated with at least one thin layer (30), or micro lenses or encapsulant as defined in claim 10.

**12.** The intermediate good according to claim 11, having the following (bottom-up) structure:

- Substrate (20) / hybrid material (30) according to any of claims 1 - 8 / transparent electrode (EL) / active layer stack (AL); or
- Substrate (20) / hybrid material (30) according to any of claims 1 - 8 / transparent electrode (EL) / active layer stack (AL); or
- Substrate (20) / multiple units of low refractive index layer (LRI) and hybrid material (30) according to any of claims 1 - 8; or substrate (20) / multiple units of the hybrid material (30) according to any of claims 1 - 8 and low refractive index layer (LRI); or

- substrate (20) / hybrid material (30) according to any of claims 1 - 8 in the form of micro-lenses; or
- Substrate (20) / hybrid material (30) according to any of claims 1 - 8 comprising additional scattering elements (SE) / transparent electrode (EL) / active layer stack (AL);
- Substrate (20) / emissive device (ED) / hybrid material (30) according to any of claims 1 - 8 in the form of an encapsulant comprising additional inorganic phosphor (IP) elements;
- Substrate (20) / hybrid material (30) / hybrid material (30) exhibiting a different refractive index / low refractive index layer (LRI).

**13.** A device comprising the intermediate good according to claim 11 or 12, the device selected from the group consisting of

- devices containing a display,
- devices that emit light,
- fenestration, and
- products containing an optical authentication element.

**14.** A suspension (5) comprising

- 0.5 - 80 wt-% nanoparticles (1) as defined in claim 1 , 4 to 7;
- 0.01 - 20 wt-% surfactants (2) as defined in claim 1 to 3;
- 0.09 - 99 wt-% matrix molecule (3) as defined in claim 1, 8 to 9;
- 0 - 99 wt-% organic solvent (4) selected from the group of water, alcohols, glycol-ethers, ketones, and aprotic polar solvents.

**15.** The suspension of claim 14, **characterized in that**

- said alcohols are selected from the group of methanol, ethanol, isopropanol, propanol, and butanol;
- said glycol-ether is propoxy-ethanol or methoxy-propanol;
- said ketones are selected from acetone and MEK;
- said aprotic polar solvents are selected from dimethyl sulfoxide, N-methyl pyrrolidone, dimethyl formamide, dimethyl acetamide.

## Patentansprüche

**1.** Ein festes Hybridmaterial (30), umfassend

- 50-90 Gew.-% Nanopartikel (1) ausgewählt aus der Gruppe der Metalloxide;
- 1-20 Gew.-% Tenside (2) ausgewählt aus der Gruppe der Phosphatester-Silane;
- 9-49 Gew.-% Polymermatrix (3), ausgewählt aus der Gruppe der transparenten Polymere,

**dadurch gekennzeichnet, dass** die Phosphatester-Silane der Formel (II) entsprechen,

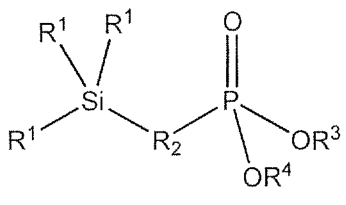

(II),

wobei:

$R^1$ $C_1$-$C_4$-Alkyl, $C_1$-$C_4$-Alkoxy, $C_1$-$C_4$-Alkoxy- $C_1$-$C_4$-alkyl bedeutet;
$R^2$ $C_1$-$C_{10}$-Alkyl-, gesättigte oder ungesättigte $C_3$-$C_{10}$-Carbocyclengruppen darstellt;
$R^3$ H, $C_1$-$C_6$-Alkyl oder $C_1$-$C_4$-Alkoxy- $C_1$-$C_4$-alkyl bedeutet.
$R^4$ $C_1$-$C_6$-Alkyl oder $C_1$-$C_4$-Alkoxy-$C_1$-$C_4$-alkyl darstellt.

**2.** Das Hybridmaterial nach Anspruch 1, wobei im Tensid (2)
$R^1$ $C_1$-$C_4$-Alkoxy darstellt;
$R^2$ $C_1$-$C_{10}$-Alkyl darstellt;
$R^3$ $C_1$-$C_6$-Alkyl darstellt;
$R^4$ $C_1$-$C_6$-Alkyl darstellt.

**3.** Das Hybridmaterial nach Anspruch 1, worin das Tensid (2) Diethylphosphato-ethyl-triethoxy-silan ist.

**4.** Das Hybridmaterial nach einem der Ansprüche 1 bis 3, wobei die Nanopartikel (1)

- einen Massenbrechungsindex von $n > 2.2$ aufweisen; und / oder
- eine thermische Leitfähigkeit von $\kappa > 2$ W/mK haben.

**5.** Das Hybridmaterial nach einem der Ansprüche 1 bis 4, wobei die Nanopartikel (1) eine erste Gruppe von Teilchen mit hohem Brechungsindex und eine zweite Gruppe von Teilchen mit hoher Wärmeleitfähigkeit umfassen.

**6.** Das Hybridmaterial nach einem der Ansprüche 1 bis 5, wobei das Nanopartikel (1) eine Kern-Schale-Struktur aufweist, wodurch

- der Kern aus der Gruppe der Metalloxide ausgewählt ist; und
- die Hülle $Al_2O_3$ ist; und

wobei die Hülle vorzugsweise weniger als 20 Gew.-% (bezogen auf das Oxidgewicht) des gesamten Teilchens beträgt.

**7.** Das Hybridmaterial nach Anspruch 1 bis 6, wobei in den Nanopartikeln (1) das Metalloxid ausgewählt ist aus Titanaten der Formel (I)

$$M_xTiyO_z \qquad (I),$$

wobei:

M ein Alkali- oder Erdalkalimetall darstellt;
x 0, eine reelle Zahl kleiner 1 oder 1 darstellt;
y 1 oder eine reelle Zahl kleiner 1, jedoch ohne 0, darstellt;
z eine reelle Zahl kleiner 1, jedoch ohne 0, darstellt;
vorausgesetzt, dass:
$z=x/2+2*y$, wenn M ein Alkalimetall darstellt oder
$z=x+2*y$, wenn M ein Erdalkalimetall darstellt oder
$z=2*y$ wenn $x=0$;
vorzugsweise Rutilphase $TiO_2$.

**8.** Das Hybridmaterial nach einem der Ansprüche 1 bis 7, wobei die Polymermatrix (3) aus der Gruppe der Silazanpolymere, Sulfonpolymere, Acrylatpolymere und Vinylpolymere ausgewählt ist.

**9.** Das Hybridmaterial nach einem der Ansprüche 1 bis 8, wobei die Polymermatrix (3) aus Silazanpolymeren der Formel (III) und Polysulfonpolymeren der Formel (IV)

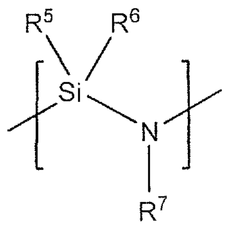

(III)

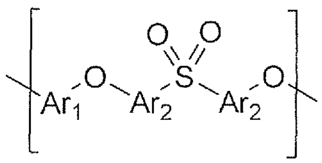

(IV)

ausgewählt ist, wobei

$R^5$, $R^6$, $R^7$ unabhängig voneinander Wasserstoff, gegebenenfalls substituiertes Alkyl, Aryl, Vinyl oder (Trialkoxysilyl)alkyl unabhängig voneinander in jeder sich wiederholenden Polymereinheit darstellen;
$Ar^1$ ein Phenyl, einen Phenylether, einen Phenylthioether, ein Bisphenol (wobei das Phenyl gegebenenfalls durch 1-3 Substituenten substituiert ist, ausgewählt aus der Gruppe der $C_1$-$C_4$-Alkyl-, Phenyl-, Halogen- und Hydroxyl), vorzugsweise Bisphenol A oder Bisphenol S darstellt;
$Ar^2$ unabhängig Phenyl (wobei das Phenyl gegebenenfalls durch 1-3 Substituenten substituiert ist, ausgewählt aus der Gruppe $C_1$-$C_4$-Alkyl, Phenyl, Halogen, Hydroxy), vorzugsweise Phenyl, darstellt.

**10.** Das Hybridmaterial nach einem der Ansprüche 1 bis 9 in Form einer dünnen Schicht, in Form von Mikrolinsen oder in Form eines Verkapselungsmittels,
wobei die Nanopartikel eine Größe von 5 - 30 nm aufweisen;
wobei die dünne Schicht eine Dicke von 30 nm - 100 μm aufweist; und / oder
wobei die Mikrolinsen einen Durchmesser von 1 - 500 μm aufweisen; und / oder
wobei das Verkapselungsmittel eine Dicke von 1 μm - 3000 μm aufweist.

**11.** Ein Zwischenprodukt (10), umfassend ein Substrat (20), das mit mindestens einer dünnen Schicht (30) beschichtet ist, oder Mikrolinsen oder Verkapselungsmittel nach Anspruch 10.

**12.** Das Zwischenprodukt nach Anspruch 11 mit der folgenden (bottom-up) Struktur:

- Substrat (20) / Hybridmaterial (30) nach einem der Ansprüche 1 - 8 / transparente Elektrode (EL) / aktiver Schichtstapel (AL); oder
- Substrat (20) / Hybridmaterial (30) nach einem der Ansprüche 1 - 8 / transparente Elektrode (EL) / aktiver Schichtstapel (AL); oder
- Substrat (20) / mehrere Einheiten von Schichten mit niedrigem Brechungsindex (LRI) und vom Hybridmaterials (30) nach einem der Ansprüche 1 - 8; oder Substrat (20) / mehrere Einheiten des Hybridmaterials (30) nach einem der Ansprüche 1 - 8 und Schicht mit niedrigem Brechungsindex (LRI); oder
- Substrat (20) / Hybridmaterial (30) nach einem der Ansprüche 1 - 8 in Form von Mikrolinsen; oder
- Substrat (20) / Hybridmaterial (30) nach einem der Ansprüche 1 - 8, umfassend zusätzliche Streuelemente (SE) / transparente Elektrode (EL) / aktiver Schichtstapel (AL);
- Substrat (20) / Emissionsvorrichtung (ED) / Hybridmaterial (30) nach einem der Ansprüche 1 - 8 in Form eines Verkapselungsmittels, das zusätzliche anorganische Phosphor(IP)-Elemente umfasst;
- Substrat (20) / Hybridmaterial (30) / Hybridmaterial (30) mit einem unterschiedlichen Brechungsindex / Schicht mit niedrigem Brechungsindex (LRI) .

**13.** Eine Vorrichtung umfassend das Zwischenprodukt nach Anspruch 11 oder 12, wobei die Vorrichtung ausgewählt ist aus der Gruppe bestehend aus

- Vorrichtungen mit einer Anzeige,
- Geräte, die Licht aussenden,
- Fensterung und
- Produkte, die ein optisches Authentifizierungselement enthalten.

**14.** Eine Suspension (5), umfassend

- 0,5 - 80 Gew.-% Nanopartikel (1) nach Anspruch 1, 4 bis 7;
- 0,01 - 20 Gew.-% Tenside (2) nach Anspruch 1 bis 3;
- 0,09 - 99 Gew.-% Matrixmolekül (3) nach Anspruch 1, 8 bis 9;
- 0 - 99 Gew.-% organisches Lösungsmittel (4), ausgewählt aus der Gruppe der Wasser, Alkohole, Glykolether,

Ketone und aprotische polare Lösungsmittel.

**15.** Die Suspension nach Anspruch 14, **dadurch gekennzeichnet, dass**

- die Alkohole ausgewählt sind aus der Gruppe von Methanol, Ethanol, Isopropanol, Propanol und Butanol;
- der Glykolether Propoxyethanol oder Methoxypropanol ist;
- die Ketone aus Aceton und MEK ausgewählt sind;
- die aprotischen polaren Lösungsmittel aus Dimethylsulfoxid, N-Methylpyrrolidon, Dimethylformamid, Dimethylacetamid ausgewählt sind.

## Revendications

**1.** Un matériau hybride solide (30) comprenant

- 50-90 % en poids de nanoparticules (1) choisies dans le groupe des oxydes métalliques;
- 1-20 % en poids d'agents tensioactifs (2) choisis dans le groupe des silanes d'esters phosphoriques;
- 9-49 % en poids de matrice polymère (3) choisie dans le groupe des polymères transparents,

**caractérisé en ce que** les silanes esters phosphoriques sont de formule (II),

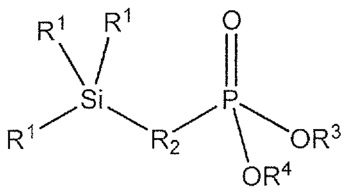

(II),

dans laquelle:

$R^1$ représente un groupe alkyle en $C_1$-$C_4$, alcoxy en $C_1$-$C_4$, alcoxy en $C_1$-$C_4$, alcoxy en $C_1$-$C_4$-alkyle en $C_1$-$C_4$;
$R^2$ représente des groupes alkyle en $C_1$-$C_{10}$, carbocycliques en $C_3$-$C_{10}$ saturés ou insaturés;
$R^3$ représente H, un groupe alkyle en $C_1$-$C_6$ ou alcoxy en $C_1$-$C_4$-alkyle en $C_1$-$C_4$;
$R^4$ représente un groupe alkyle en $C_1$-$C_6$ ou alcoxy en $C_1$-$C_4$-alkyle en $C_1$-$C_4$.

**2.** Le matériau hybride selon la revendication 1, dans lequel dans l'agent tensioactif (2)
$R^1$ représente un groupe alcoxy en $C_1$-$C_4$;
$R^2$ représente un groupe alkyle en $C_1$-$C_{10}$;
$R^3$ représente un groupe alkyle en $C_1$-$C_6$;
$R^4$ représente un groupe alkyle en $C_1$-$C_6$.

**3.** Le matériau hybride selon la revendication 1, dans lequel le tensioactif (2) est le diéthylphosphato-éthyl-triméthoxysilane.

**4.** Le matériau hybride selon l'une quelconque des revendications 1 à 3, dans lequel les nanoparticules (1)
ont un indice de réfraction global de $n > 2.2$; et/ou
ont une conductivité thermique apparente $\kappa > 2$ W/mK.

**5.** Le matériau hybride selon l'une quelconque des revendications 1 à 4, dans lequel les nanoparticules (1) comprennent un premier groupe de particules présentant un indice de réfraction élevé et un deuxième groupe de particules présentant une conductivité thermique élevée.

**6.** Le matériau hybride selon l'une quelconque des revendications 1 à 5, dans lequel les nanoparticules (1) sont d'une structure noyau-enveloppe, dans lequel
le noyau est choisi dans le groupe des oxydes métalliques; et
l'enveloppe est de l'$Al_2O_3$; et
dans laquelle l'enveloppe représente de préférence moins de 20 % en poids (sur la base du poids de l'oxyde) de

la particule entière.

**7.** Le matériau hybride selon la revendication 1 à 6, dans lequel, dans les nanoparticules (1), ledit oxyde métallique est choisi parmi les titanates de formule (I)

$$M_xTiyO_z \qquad (I),$$

où

M représente un métal alcalin ou alcalino-terreux;
x représente 0, un nombre réel inférieur à 1 ou 1;
y représente 1 ou, un nombre réel inférieur à 1 mais excluant 0;
z représente un nombre réel inférieur à 1 mais excluant 0;
à condition que:

z=x/2+2*y si M représente un métal alcalin ou
z=x+2*y si M représente un métal alcalino-terreux ou
z=2*y si x=0;

de préférence en phase rutile $TiO_2$.

**8.** Le matériau hybride selon l'une quelconque des revendications 1 à 7, dans lequel la matrice polymère (3) est choisie dans le groupe des polymères silazanes, des polymères sulfones, des polymères acrylates et des polymères vinyliques.

**9.** Le matériau hybride selon l'une quelconque des revendications 1 à 8, dans lequel la matrice polymère (3) est choisie parmi les polymères silazane de formule (III) et les polymères polysulfone de formule (IV)

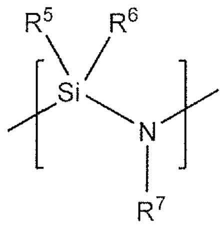

(III)

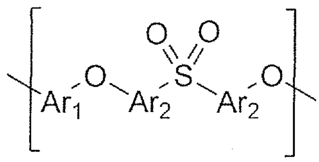

(IV)

où

$R^5$, $R^6$, $R^7$ représentent indépendamment l'un de l'autre un atome d'hydrogène, un groupe alkyle, aryle, vinyle ou (trialcoxysilyl)alkyle éventuellement substitué, indépendamment dans chaque motif répétitif polymère;
$Ar^1$ représente un phényle, un phényléther, un phénylthioéther, un phénylthioéther, un bisphénol (ledit phényle étant éventuellement substitué par 1 à 3 substituants choisis dans le groupe des alkyle en $C_1$-$C_4$, phényle, halogène, hydroxyle), de préférence le bisphénol A ou le bisphénol S;
$Ar^2$ représente indépendamment un groupe phényle (ledit groupe phényle étant éventuellement substitué par 1 à 3 substituants choisis dans le groupe des groupes alkyle en $C_1$-$C_4$, phényle, halogène, hydroxy), de préférence un groupe phényle.

**10.** Le matériau hybride selon l'une quelconque des revendications 1 à 9 sous la forme d'une couche mince, sous la forme de micro lentilles ou sous la forme d'un encapsulant,

- lesdites nanoparticules ayant une taille de 5 à 30 nm;
- ladite couche mince ayant une épaisseur de 30 nm - 100 μm; et/ou
- lesdites microlentilles ayant un diamètre de 1 à 500 μm; et/ou
- ledit encapsulant ayant une épaisseur de 1 μm - 3000 μm.

**11.** Un produit intermédiaire (10) comprenant un substrat (20) revêtu d'au moins une couche mince (30), ou des microlentilles ou un encapsulant tel que défini dans la revendication 10.

**12.** Le produit intermédiaire selon la revendication 11, ayant la structure (ascendante) suivante:

- substrat (20) / matériau hybride (30) selon l'une des revendications 1 à 8 / électrode transparente (EL) / pile de couches actives (AL); ou
- substrat (20) / matériau hybride (30) selon l'une des revendications 1 à 8 / électrode transparente (EL) / pile de couches actives (AL); ou
- substrat (20) / plusieurs unités de couche à faible indice de réfraction (LRI) et de matériau hybride (30) selon l'une quelconque des revendications 1 à 8; ou substrat (20) / plusieurs unités du matériau hybride (30) selon l'une quelconque des revendications 1 à 8 et couche à faible indice de réfraction (LRI); ou
- substrat (20) / matériau hybride (30) selon l'une quelconque des revendications 1 à 8 sous forme de microlentilles; ou
- substrat (20) / matériau hybride (30) selon l'une quelconque des revendications 1 à 8 comprenant des éléments de diffusion supplémentaires (SE) / électrode transparente (EL) / pile de couches actives (AL);
- substrat (20) / dispositif émissif (ED) / matériau hybride (30) selon l'une quelconque des revendications 1 à 8 sous la forme d'un encapsulant comprenant des éléments phosphorés inorganiques (IP) supplémentaires;
- substrat (20) / matériau hybride (30) / matériau hybride (30) présentant un indice de réfraction différent / couche à faible indice de réfraction (LRI).

**13.** Un dispositif comprenant le produit intermédiaire selon la revendication 11 ou 12, le dispositif étant choisi dans le groupe constitué par

- les dispositifs contenant un écran,
- les appareils qui émettent de la lumière,
- le fenêtrage, et
- les produits contenant un élément d'authentification optique.

**14.** Une suspension (5) comprenant

- 0,5 - 80 % en poids de nanoparticules (1) telles que définies dans les revendications 1, 4 à 7;
- 0,01 - 20 % en poids d'agents tensioactifs (2) tels que définis dans les revendications 1 à 3;
- 0,09 - 99 % en poids de molécule de matrice (3) telle que définie dans les revendications 1, 8 à 9;
- 0 - 99 % en poids de solvant organique (4) choisi dans le groupe constitué par l'eau, les alcools, les éthers de glycol, les cétones et les solvants polaires aprotiques.

**15.** La suspension selon la revendication 14, **caractérisée en ce que**

- lesdits alcools sont choisis dans le groupe du méthanol, de l'éthanol, de l'isopropanol, du propanol et du butanol;
- ledit glycol-éther est du propoxy-éthanol ou du méthoxy-propanol;
- lesdites cétones sont choisies parmi l'acétone et le MEK;
- lesdits solvants polaires aprotiques sont choisis parmi le diméthylsulfoxyde, la N-méthylpyrrolidone, le diméthylformamide, le diméthylacétamide.

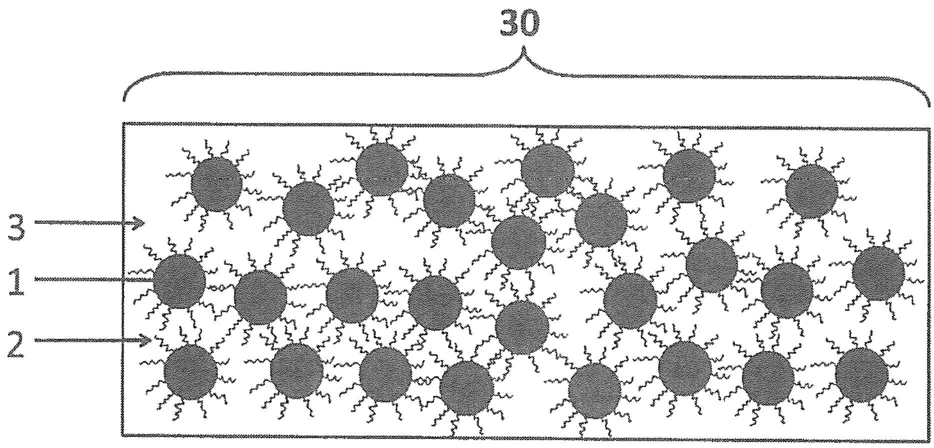


Fig. 1

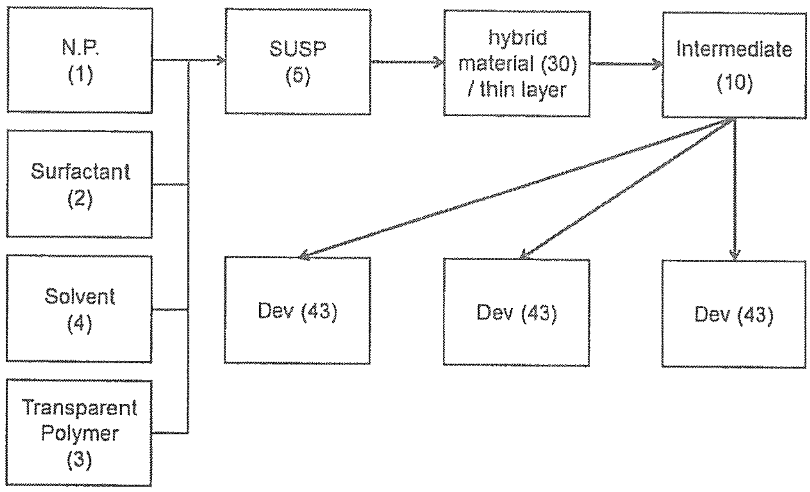


Fig. 2

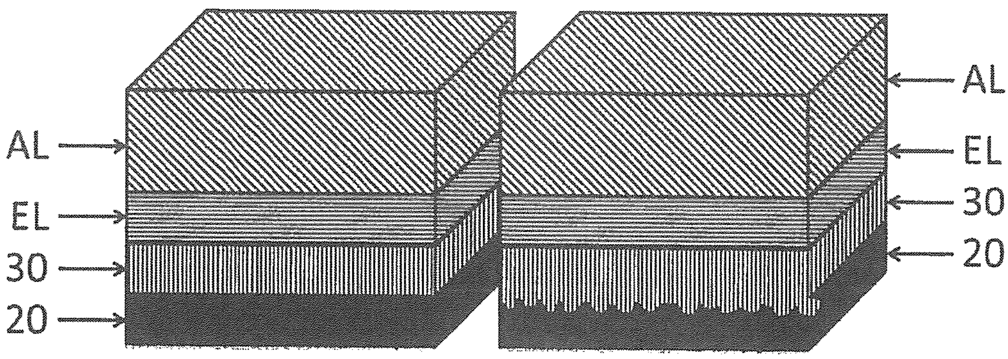


Fig. 3 A B

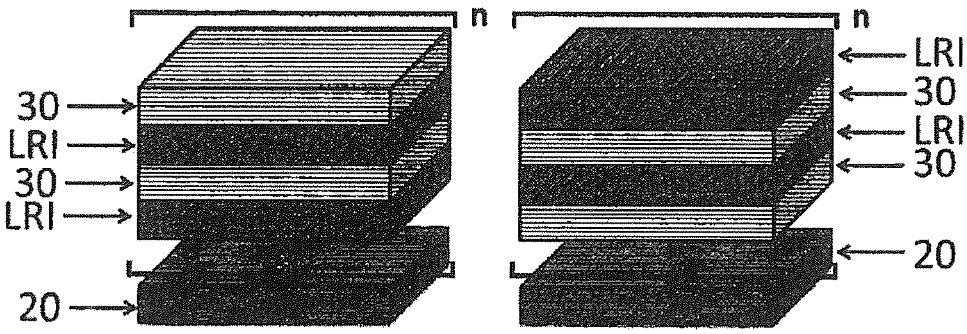


Fig. 4

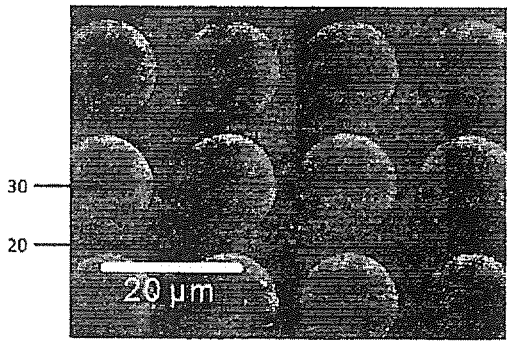


Fig 5

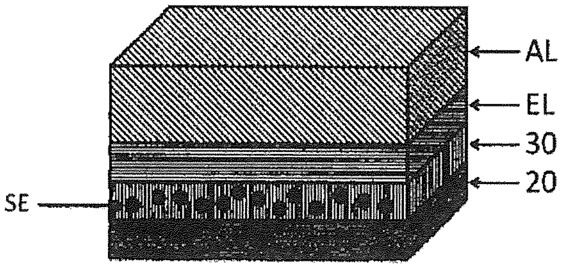


Fig. 6

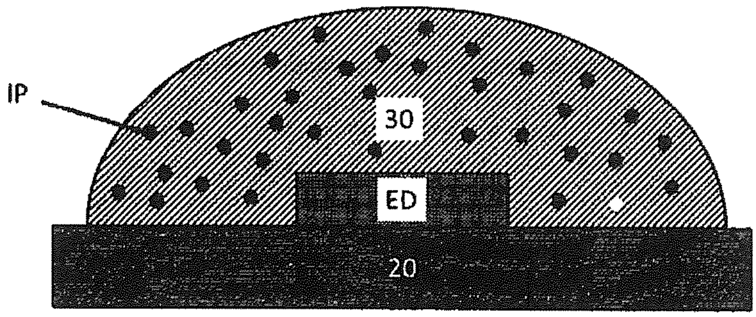


Fig. 7

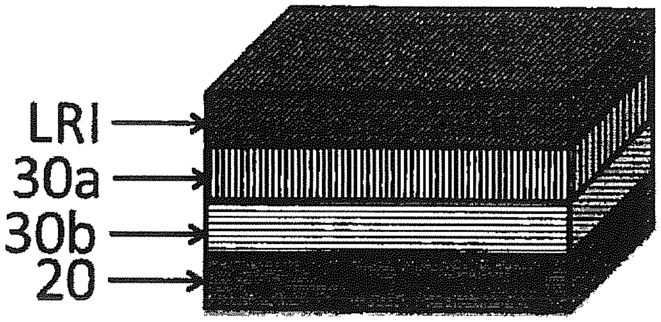


Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010002562 A, Liu
- EP 2586826 A, Yamazaki
- US 20140045323 A, Gonen Williams
- WO 2014161100 A, Lüchinger


### Non-patent literature cited in the description


- **LIU et al.** *Colloids and Surfaces A: Physicochem. Eng. Aspects,* 2011, vol. 377, 138-143